**Europäisches Patentamt**

**European Patent Office**

**Office européen des brevets**

(19)

(11) Numéro de publication : **0 485 314 A1**

# (12) DEMANDE DE BREVET EUROPEEN

(21) Numéro de dépôt : **91470025.7**

(22) Date de dépôt : **06.09.91**

(51) Int. Cl.[5] : **C23C 8/38**, C21D 1/09

(30) Priorité : **19.09.90 FR 9011647**

(43) Date de publication de la demande :
**13.05.92 Bulletin 92/20**

(84) Etats contractants désignés :
**AT BE CH DE DK ES GB GR IT LI LU NL SE**

(71) Demandeur : **UGINE ACIERS DE CHATILLON ET GUEUGNON (Société anonyme)**
**Immeuble Ile-de France, 4, Place de la Pyramide**
**F-92070 Paris La Défense, Cédex 33 (FR)**

(72) Inventeur : **de Gelis, Pierre**
**4 ter, rue Bonnemain**
**F-78104 Saint Germain en Laye (FR)**
Inventeur : **Pontet, Joelle**
**23, rue de la Paix**
**ZAC des Gachères, F-71130 Gueugnon (FR)**
Inventeur : **Piet, Gérard**
**1, rue Maurice Berteaux**
**F-95870 Bezons (FR)**
Inventeur : **Pacqueau, Gérard**
**Aux Angles**
**Montmorte, F-71320 Toulon sur Arroux (FR)**

(74) Mandataire : **Ventavoli, Roger**
**TECHMETAL PROMOTION Domaine de l'IRSID Voie romaine BP 321**
**F-57213 Maizières-lès-Metz Cédex (FR)**

(54) **Dispositif de traitement superficiel d'une plaque ou d'une tôle d'un matériau métallique par plasma basse température.**

(57) L'invention a pour objet un dispositif de traitement superficiel par plasma basse température d'un matériau métallique (8) immobile sous forme de plaque ou de tôle. Elle comprend une enceinte étanche (1) munie de moyens (3,4) d'introduction d'un gaz plasmagène et de moyens (6) de régulation de la pression, ladite enceinte (1) renfermant un support (7) en contact avec ledit matériau (8) et au moins une électrode (10) fixe ou mobile sur laquelle est ménagée une surface (13), dite surface active, faisant face audit matériau (8) et définissant un espace (12) entre elle et la surface (9) dudit matériau. L'électrode (10) est munie de moyens (11) pour la maintenir et régler la distance entre sa surface active et la surface dudit matériau. Des moyens (14,15) sont prévus pour créer entre ledit matériau (8) et ladite électrode (10) une différence de potentiel de signe et de valeur absolue donnés, et des moyens sont prévus pour générer un plasma basse température présent dans ledit espace.

Fig.1.

EP 0 485 314 A1

La présente invention concerne le traitement superficiel d'une plaque ou d'une tôle d'un matériau métallique immobile. Elle permet, de manière avantageuse, notamment la mise en oeuvre de procédés connus d'amélioration de la résistance à la corrosion dudit matériau, d'amélioration de l'adhérence d'un revêtement sur sa surface, ou de coloration de sa surface, ces procédés étant fondés sur l'exposition de la surface dudit matériau à un plasma basse température.

On connaît des procédés de traitement superficiel de matériaux métalliques utilisant un plasma dit "basse température" ou "froid", par opposition aux plasmas de fusion thermonucléaires appelés plasmas "chauds". Le degré d'ionisation d'un plasma basse température est faible ($10^{-7}$ à $10^{-3}$). L'énergie électrique est transférée aux électrons qui sont assez peu nombreux, mais très énergétiques (1 à 10 eV). Ils excitent ainsi le gaz à chauffer, dont la température peut aller de 20 à 700°C environ, et produisent des espèces excitées en grand nombre. Une des méthodes de production d'un tel plasma consiste à établir une décharge électroluminescente entre deux électrodes (cathode et anode) se faisant face au sein d'une atmosphère raréfiée, sous une pression inférieure à 1000 Pa. D'autres méthodes de production du plasma, telles que l'excitation de l'atmosphère raréfiée par des micro-ondes ou des radiofréquences sont également connues, et applicables au traitement superficiel des matériaux métalliques.

La demanderesse a elle-même déposé des demandes de brevet français sur des procédés de traitement superficiel de matériaux métalliques par des plasmas froids. La demande FR 8805091 concerne un procédé pour améliorer la résistance à la corrosion d'un échantillon. A cet effet, ledit échantillon est polarisé négativement et exposé à un plasma comportant, au moins à l'état de traces, un gaz oxydant dans une enceinte où la pression est de 1 à 1000 Pa. Dans un exemple de mise en oeuvre, le plasma est généré par l'établissement d'une tension de l'ordre de 100 à 5000 V entre une anode et une cathode, cette dernière étant constituée par l'échantillon lui-même, et le temps de traitement varie de 1 s à 10 min environ.

Le procédé décrit dans la demande FR 8913879 vise à améliorer l'adhérence sur la surface d'un échantillon d'un revêtement qui serait ultérieurement appliqué sur cette surface. Comme dans le procédé précédent, l'échantillon à traiter doit être polarisé négativement.

Enfin, le procédé décrit dans la demande FR 89 08085 permet de colorer la surface d'un échantillon, tel qu'une plaque d'acier inoxydable. Celui-ci est placé dans une atmosphère raréfiée comportant un plasma oxydant. Contrairement aux deux procédés précédents, l'échantillon est polarisé positivement. Des atomes sont arrachés par le plasma à une électrode dite électrode-source (cathode) placée face à l'échantillon. Ces atomes sont oxydés par le plasma, et les oxydes ainsi formés vont se déposer sur l'échantillon. Cette couche d'oxydes procure à la surface de l'échantillon une coloration due à des phénomènes d'interférences lumineuses, dont la teinte est fonction de l'épaisseur de la couche et dépend donc des conditions opératoires et de la durée de l'expérience.

La demanderesse a également déposé une demande de brevet français FR 9007061 concernant un dispositif permettant d'appliquer les divers procédés précédemment mentionnés au traitement de bandes métalliques de grande longueur en défilement.

Le but de la présente invention est de proposer un dispositif permettant de traiter superficiellement des pièces unitaires fixes, généralement de forme plane, selon ces mêmes procédés.

A cet effet, l'invention a pour objet un dispositif de traitement superficiel par plasma basse température d'un matériau métallique immobile sous forme de plaque ou de tôle, caractérisé en ce qu'il comprend une enceinte étanche munie de moyens d'introduction d'un gaz ou d'un mélange de gaz plasmagène, et de moyens de régulation de la pression permettant de la maintenir à une valeur donnée, ladite enceinte renfermant un support en contact avec ledit matériau et au moins une électrode sur laquelle est ménagée une surface, dite surface active, faisant face audit matériau et définissant un espace entre elle et la surface dudit matériau, l'électrode étant munie de moyens pour la maintenir et régler la distance entre sa surface active et la surface dudit matériau, des moyens étant prévus pour créer entre ledit matériau et ladite électrode une différence de potentiel de signe et de valeur absolue donnés, et des moyens étant prévus pour générer un plasma basse température présent dans ledit espace.

Dans une réalisation préférentielle, la ou les électrodes ont une surface active de dimensions sensiblement plus faibles que celles du matériau à traiter, et peuvent être déplacées au cours du traitement de manière à pouvoir traiter l'intégralité de la surface du matériau.

Comme on l'aura compris, l'invention permet d'appliquer un traitement superficiel par plasma froid à une tôle ou à une plaque métallique, notamment d'acier, maintenue immobile. Dans la version la plus élémentaire de ce dispositif, l'électrode qui fait face à la plaque à traiter est fixe, et a une aire au moins égale à celle de ladite plaque, dont toute la surface est traitée simultanément. Dans une autre configuration de l'installation, l'électrode a une aire relativement petite par rapport à celle de la pièce, et est mobile, de façon à pouvoir traiter successivement toute la surface de la plaque, ou seulement une partie de celle-ci. Dans le cas de l'application du dispositif à la coloration de la plaque, il est ainsi possible de ne colorer que des plages de celle-ci, voire, si l'on utilise une électrode de très faible surface, de réaliser la coloration selon des traits fins, pouvant former de véritables dessins à la manière d'un crayon.

L'invention sera mieux comprise à la lecture de la description qui suit, faisant référence aux planches de dessins annexées,sur lesquelles :

– la figure 1 représente en coupe et en perspective une installation de coloration d'une plaque métallique selon l'invention, dans laquelle l'électrode-source à une aire sensiblement identique à celle de la tôle à traiter ;

– la figure 2 représente vue de dessus une autre installation dans laquelle l'électrode-source est mobile selon une dimension de la surface de la plaque à traiter et a une surface sensiblement plus faible que celle de la tôle ;

– la figure 3 représente vue de dessus une variante de l'installation de la figure 2, dans laquelle l'électrode-source a une surface très réduite par rapport à celle de la plaque, et est mobile selon les deux dimensions de la surface de la tôle.

Ces figures et l'essentiel de la description qui suit se rapportent au cas d'installation destinées à exécuter sur la tôle des traitements de coloration. Mais comme il sera dit plus loin, ces installations peuvent être facilement adaptées à l'exécution des autres traitements superficiels par plasma auxquels il a été fait allusion précédemment.

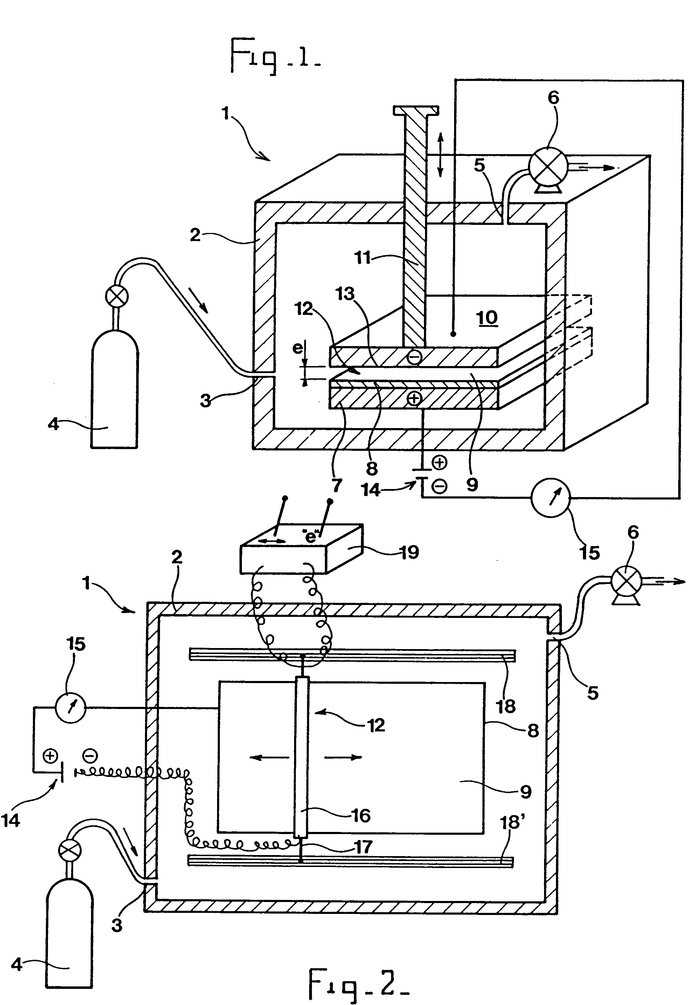

La figure 1 montre une telle installation dans sa version la plus élémentaire. Elle comporte une enceinte étanche 1, dont la paroi 2 est munie d'un orifice 3 permettant d'introduire dans l'enceinte le gaz ou le mélange gazeux plasmagène contenu dans un récipient 4. Dans le cas exemplifié, ce gaz ou ce mélange gazeux doit contenir au moins un gaz dont la molécule renferme des atomes d'oxygène, tel que l'oxygène lui-même, l'ozone, l'air, les oxydes d'azote, la vapeur d'eau. Un autre orifice 5 permet de relier l'intérieur de l'enceinte 1 à un dispositif d'aspiration 5 qui permet de maintenir la pression dans l'enceinte à une valeur connue et contrôlée. Cette pression doit être telle que, conjuguée aux autres paramètres opératoires de l'installation, elle permette la production dans l'enceinte par décharge électroluminescente d'un plasma froid. Pratiquement, une telle pression doit de toute façon être inférieure à 1000 Pa.

A l'intérieur de l'enceinte 1 se trouve un support 7 sur lequel est placée la tôle ou la plaque 8 à colorer qui est le plus souvent en acier inoxydable. Le support 7 est préférentiellement en un matériau conducteur de l'électricité. Optionnellement, il est en un matériau magnétique afin que la tôle 8, si elle est également magnétique, soit maintenue contre lui sans qu'un dispositif de fixation particulier soit nécessaire. Si le support n'est pas ou trop faiblement magnétique, le champ magnétique permettant de maintenir la tôle 8 peut également être créé ou renforcé par des moyens adaptés non représentés, faisant du support 7 un électro-aimant. Sans sortir de l'invention, le maintien de la tôle 8 sur le support 7 peut, bien sûr, ête assuré par tout autre moyen approprié, mais un support magnétique présente l'avantage de ne pas nécessiter de manipulations complexes ou d'altérations de la tôle 8, et de laisser la surface à colorer 9 de cette dernière entièrement découverte, y compris ses bords. En regard de la surface à colorer 9 de la tôle 8 est placée l'électrode-source 10 qui fournit les atomes dont les oxydes doivent se déposer sur la surface 9 de la tôle 8 et donner naissance à sa coloration. L'électrode-source 10 est munie de moyens de maintien, symbolisés par la tige 11, qui permettent, depuis l'extérieur de l'enceinte, de régler la largeur "e" de l'espace 12 qui est défini par la surface à colorer 9 de la tôle 8 et la surface active 13 de l'électrode-source 10 qui lui correspond.

Dans cet exemple de mise en oeuvre, la surface 9 de la tôle à colorer 8 et la surface active 13 de l'électrode-source 10 qui se font face sont d'aires sensiblement identiques, et sont disposées de manière à ce que chaque point de la tôle 8 se trouve face à un point de l'électrode-source 10. D'autre part, le support 7, dans le cas où il est en un matériau conducteur de l'électricité, et l'électrode-source 10 sont chacun reliés à l'un des pôles d'un alimentation électrique 14 extérieure à l'enceinte. Si le support 7 est en matériau isolant, il faut alors prévoir des moyens pour relier la tôle directement à l'alimentation électrique 14. Pour l'application du dispositif à la coloration de la tôle 8, le support 7 est relié au pôle ⊕ de l'alimentation 14, et l'ensemble qu'il forme avec la tôle 8 joue un rôle d'anode. L'électrode-source 11 est reliée au pôle ⊖ de l'alimentation 14, et joue un rôle de cathode. Un dispositif de régulation 15 permet de contrôler la différence de potentiel entre le support 7 et l'électrode-source 10. De préférence, le support 7 et l'électrode-source 10 sont refroidis, par exemple par des moyens non représentés assurant une circulation d'eau à leur intérieur, de manière à maintenir la tôle 8 et l'électrode-source 10 à des températures sensiblement constantes et uniformes sur toute leurs surfaces externes respectives.

C'est à l'intérieur de l'espace 12 qu'est créé par décharge électroluminiscente le plasma froid qui assure le traitement de coloration de la surface 9 de la tôle 8.

Comme exposé dans le document FR 8908085 déjà cité, cette coloration est obtenue par le dépôt sur la surface 9 de la tôle 8 d'une mince (quelques centaines d'Å) couche d'oxydes métalliques, dont les atomes métalliques ont été arrachés à la surface 13 de l'électrode-source 10. La nature de ces oxydes dépend de celle du matériau constituant l'électrode-source. Une électrode en acier inoxydable ferritique permet de former un dépôt à base d'oxydes de fer et de chrome. Une électrode en acier inoxydable austénitique permet de former un dépôt à base d'oxydes de fer, de chrome et de nickel, etc... Pour obtenir un dépôt particulièrement résistant à la corrosion, on peut employer une électrode-source en métal noble pur (titane, chrome ou aluminium par exemple) qui permet de former un dépôt ne comportant que des oxydes de ce métal. Les autres conditions opératoires nécessaires à l'exécution d'un tel traitement sont :

– différence de potentiel entre l'électrode-source 10 et l'ensemble formé par le support 7 et la tôle 8 : 200 à 5000 V environ ;

– densité de courant dans la tôle 8 : 1 à 100 mA/cm2 .

– temps pendant lequel une portion donnée de la tôle 8 se trouve face à l'électrode-source 10 : jusqu'à 60 minutes ;

– distance "l" entre la tôle 8 et l'électrode-source 10 : 1 mm à plusieurs centimètres, de préférence 1 à 50 mm.

Pour des conditions expérimentales données, la coloration obtenue dépend du temps de traitement, et il est aisé de déterminer expérimentalement quelle couleur correspond à quel temps de traitement, c'est-à-dire au temps pendant lequel une portion de la surface à colorer de la tôle 8 fait face à l'électrode-source 10. L'épaisseur de la couche d'oxydes augmente si le temps de traitement augmente, si la densité de courant dans la tôle 8 augmente, si la différence de potentiel entre la tôle 8 et l'électrode-source 10 augmente, si la largeur "e" de l'espace 12 diminue. Dans ces conditions, il va de soi que, si on désire obtenir une coloration uniforme sur toute la surface 9 de la tôle 8, celle-ci et la surface active 13 de l'électrode-source 10 doivent être parallèles, autrement dit la largeur "e" doit être uniforme dans tout l'espace 12. Un défaut de parallélisme conduirait à l'obtention d'une coloration en dégradé, que l'on peut d'ailleurs rechercher de manière délibérée.

Pour éviter que le plasma ne se forme à partir de l'ensemble de l'électrode-source 10, ce qui créerait des phénomènes parasites nuisant à une bonne régularité du fonctionnement de l'appareil et provoquerait une usure exagérée de l'électrode-source 10, on peut gainer l'électrode-source 10 par un matériau isolant, tel que de la Sirilite ®, en ne laissant découverte que la surface active 18 qui fait face à la surface 13 de la tôle 8. Ce gainage (non représenté sur la figure 1) peut être remplacé par un anneau de garde, c'est-à-dire une électrode polarisée positivement, dont la forme épouse celles des surfaces de l'électrode-source 10 autres que la surface active 13, et est placée à une faible distance d'elles, de l'ordre de 0,5 mm à quelques cm. Cette distance est déterminée de manière à rendre impossible la formation d'un plasma entre les faces en regard de ces deux électrodes compte tenu des autres conditions expérimentales. Elle est de toute façon inférieure à la distance entre la surface active 13 de l'électrode-source et la surface 9 de la tôle 8.

D'autre part, on peut adjoindre à l'installation tout aménagement visant à augmenter le rendement d'ionisation dans le plasma. Un tel aménagement peut consister, de manière connue, en des moyens pour créer un champ magnétique entre l'électrode-source 10 et la tôle 8, tels qu'un aimant permanent ou un électro-aimant. Le champ magnétique a pour effet d'allonger le parcours des électrons, et on obtient ainsi l'augmentation recherchée du rendement d'ionisation du plasma.

Si on désire colorer diverses plages de la tôle 8 de manière non uniforme, par exemple pour créer des dessins, il est possible de réaliser plusieurs traitements successifs de la tôle en masquant certaines parties de celle-ci par des caches de diverses formes, changés entre chaque traitement. De cette façon, à l'issue du dernier traitement, les différentes plages de la tôle auront été exposées à l'action du plasma pendant des temps différents, en fonction des caches qui les auront ou non recouvertes lors des diverses étapes du traitement. Comme à chaque temps total d'exposition correspond une couleur différente (pour des paramètres opératoires de l'installation par ailleurs constants), on obtient sur la tôle les dessins colorés recherchés. Les caches peuvent être constitués par un matériau solide quelconque (papier, ruban adhésif...) appliqué contre la tôle, ou même par une encre déposée sur la tôle, par exemple au moyen d'un crayon ou d'un tampon.

L'installation telle qu'elle vient d'être décrite présente cependant des inconvénients, principalement lorsqu'on désire colorer des tôles de grandes dimensions (plusieurs dizaines de cm de côté). Dans ces conditions, comme il est nécessaire de prévoir des électrodes-sources de taille au moins équivalente à celle de la tôle, leur positionnement précis par rapport à la tôle peut s'avérer délicat. D'autre part, pour obtenir à travers de telles électrodes la densité de courant nécessaire conjuguée à une différence de potentiel suffisante, il faudrait prévoir une installation d'alimentation électrique d'une puissance relativement importante. A titre d'exemple, le traitement d'une tôle carrée de 1 m de côté, sous une tension entre anode et cathode de 1200 V et une densité de courant de 10 mA/cm² nécessiterait une alimentation de puissance minimale 120 kW. Pour toutes ces raisons, il peut être préférable de réduire la taille de l'électrode-source, tout en conservant malgré tout la possibilité de traiter des tôles de grande surface.

C'est avec cet objectif en vue qu'a été conçue l'installation représentée sur la figure 2. La tôle à traiter 8 de forme rectangulaire est placée comme précédemment sur un support conducteur (non visible ici), relié au pôle ⊕ de l'alimentation électrique 14. Mais cette fois l'électrode-source 16 a une surface nettement inférieure à celle de la tôle 8. Dans l'exemple représenté, elle se présente sous la forme d'une pièce dont la face en regard de la surface de la tôle 8 est rectangulaire. Sa longueur est égale ou légèrement supérieure à la dimension du petit côté de la tôle 8, et sa largeur est faible par rapport à la dimension du grand côté de la tôle 8. L'électrode-source 16 est comme précédemment reliée au pôle $\ominus$ de l'alimentation électrique 14, et elle est fixée sur un support 17, qui maintient sa surface active à une distance "e" de la surface 9 de la tôle 8. Sur ce support 17 sont prévus des moyens pour le déplacer sur des rails 18,18′ disposés parallèlement aux grands côtés de la tôle 8 et de son support, de telle manière qu'au cours de ce déplacement continu ou discontinu, la surface active de l'électrode 16 puisse successivement être mise en regard de toutes les zones à colorer de la surface de la tôle 8. Le déplacement du support 17 est commandé par un actionneur 19 extérieur à l'enceinte 1, grâce auquel l'opérateur peut régler, manuellement ou par l'intermédiaire d'une installation de traitement des données convenablement programmée, la vitesse de déplacement de l'électrode-source 16 et de son support 17 et la distance "e". Ces paramètres, conjugués aux paramètres électriques fixés grâce à l'alimentation 14 et à la régulation 15, déterminent la couleur obtenue sur la tôle 8 après le passage de l'électrode-source 16. L'électrode-source 16 est, en outre, préférentiellement munie de moyens de refroidissement non représentés, de même que le support de la tôle 8.

Avec une telle installation, la puissance de l'alimentation électrique nécessaire peut être réduite, par rapport au cas vu précédemment de l'électrode-source couvrant toute la surface de la tôle, dans un rapport identique au rapport des surfaces respectives de l'électrode et de la tôle, toutes choses étant égales par ailleurs. Cependant, le temps nécessaire pour traiter l'intégralité de la tôle se trouve augmenté dans les mêmes proportions. Le choix de la largeur de l'électrode-source est donc le résultat d'un compromis entre l'intérêt d'avoir une alimentation électrique de puissance modérée et une électrode-source de dimensions réduites, et la nécessité de ne pas allonger exagérément le temps de traitement d'une tôle pour satisfaire les impératifs de productivité de l'installation.

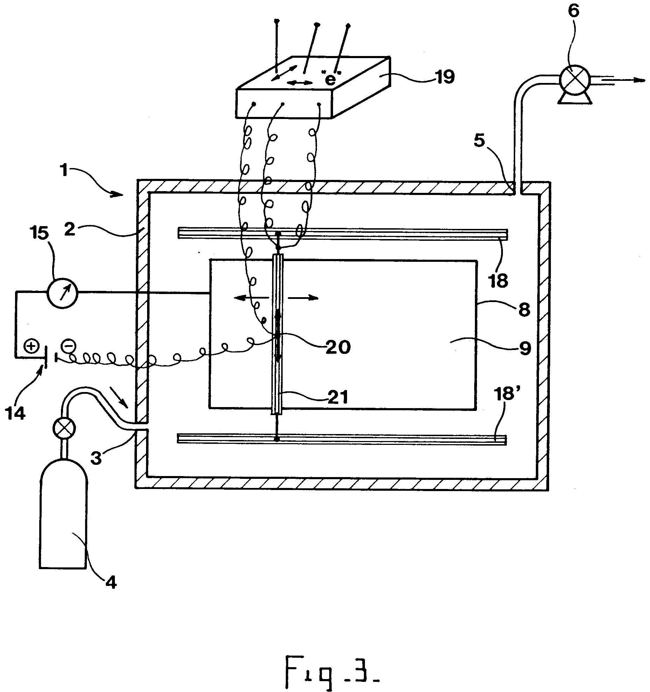

L'installation représentée sur la figure 3 est une variante de celle précédemment décrite. Elle est adaptée à l'exécution directe sur la surface 9 de la tôle 8 de dessins composés de traits de faible épaisseur sans qu'il soit forcément nécessaire d'utiliser des caches. A cet effet, l'électrode-source 20 présente une surface active de dimension très réduite par rapport à la surface totale de la tôle 8, de manière à pouvoir réaliser une coloration ponctuelle de la surface 9 de la tôle 8. Cette surface active est, par exemple, circulaire ou carrée, et son diamètre ou son côté est sensiblement identique à l'épaisseur du trait ou du point qu'on désire obtenir. L'électrode-source 20 est montée sur un support 21 qui, comme le support 17 de l'installation de la figure 2, prend appui et peut se déplacer sur les rails 18,18′ parallèles aux grands côtés de la tôle 8. Mais ici, le support 21 permet en plus à l'électrode-source de se déplacer sur toute la longueur de la plus petite dimension de la tôle 8. En combinant ces deux mouvements, il est donc possible d'appliquer le traitement de coloration à une succession de points choisis sur toute la surface de la tôle 8. On peut ainsi réaliser de véritables dessins, d'une manière analogue à ce qui est effectué par les "tables traçantes" qui restituent sur papier des courbes calculées par ordinateur. Si on ajoute à ces deux possibilités le réglage de la distance "e" entre la surface active de l'électrode-source 20 et la surface 9 de la tôle 8, l'électrode-source peut se déplacer dans les trois dimensions de l'espace. Des moyens 19 extérieurs à l'enceinte 1 reliés au support 21 et à l'électrode-source 20 commandent leurs déplacements. Comme précédemment, cette commande peut être effectuée de façon manuelle ou informatisée.

Il est souhaitable que l'installation permette de remplacer le support 21 et l'électrode-source ponctuelle 20 par le support 17 et l'électrode-source de plus grande surface 16, de manière à pouvoir la transformer en installation selon la figure 2. Avec le même appareil, il est ainsi possible de réaliser un dessin sur une tôle dont la surface entière a été préalablement ou sera ensuite colorée. On peut également prévoir la possibilité de remplacer l'électrode-source ponctuelle 20 par un crayon dont la pointe, de même dimension que la surface active de l'électrode-source 20, peut déposer sur la surface 9 de la tôle 8 une encre constituant un masque. Ainsi, si on désire exécuter par exemple un dessin vert sur un fond rouge, sachant que le temps de traitement $t_r$ nécessaire pour obtenir la coloration rouge est inférieur au temps $t_v$ nécessaire pour obtenir la coloration verte, on peut procéder de la façon suivante :

– on traite à l'aide de l'électrode-source ponctuelle 20 les parties de la tôle correspondant au dessin de manière que chaque point concerné subisse le traitement pendant un temps $(t_v - t_r)$.

– on traite ensuite l'ensemble de la surface de la tôle au moyen de l'électrode-source de plus grande surface 16, de manière que tous les points de la surface subissent le traitement pendant un temps $t_r$.

Il en résulte que les zones formant le dessin ont subi le traitement pendant un temps $(t_v - t_r) + t_r = t_v$ et sont donc vertes, alors que le restant de la tôle a été traité pendant un temps $t_r$, et est donc rouge.

Si, inversement, on désire obtenir un dessin rouge sur un fond vert :

– on trace sur la tôle à l'aide d'un crayon encreur utilisé en lieu et place de l'électrode ponctuelle 20, le dessin que l'on désire voir apparaître ;

– on traite l'ensemble de la tôle à l'aide de l'électrode-source 16 pendant un temps ($t_v$ - $t_r$) ;

– on enlève l'encre ;

– on recommence le traitement de l'ensemble de la tôle pendant un temps $t_r$.

Les zones formant le dessin ont été traitées pendant un temps $t_r$ et sont donc rouges, et le restant de la tôle a été traité pendant un temps $t_v$ et est donc vert.

Que l'électrode-source ponctuelle 20 soit utilisé ou non, l'installation selon la figure 3 apparaît donc comme un moyen partirulièrement commode de réaliser sur la tôle 8 des dessins au tracé fin et complexe, particulièrement lorsque les déplacements du support 21 peuvent être commandés par ordinateur.

Après avoir déterminé expérimentalement quelles conditions de traitement correspondent aux différentes couleurs que l'on désire obtenir, en combinant les traitements par l'électrode-source ponctuelle 20, par l'électrode-source de plus grande surface 16 et l'utilisation de caches, il est possible d'obtenir des tôles colorées selon une variété infinie de couleurs et de motifs.

Bien entendu, des modifications peuvent être apportées aux installations telles qu'elles viennent d'être décrites sans sortir de l'esprit de l'invention. En particulier, on peut concevoir une installation équipée non pas d'une, mais de plusieurs électrodes mobiles identiques ou différentes, permettant de réaliser simultanément plusieurs étapes d'un traitement de coloration complexe, ce qui permettrait d'améliorer la productivité de l'installation.

On peut également équiper l'installation d'un dispositif permettant de mesurer en continu la distance "e" effective entre la surface active de l'électrode-source et la surface de la tôle à colorer. Il est ainsi plus aisé de maîtriser la coloration de plaques qui, par exemple, auraient été préalablement embouties, et présenteraient une surface non uniformément plane. L'indication de la mesure de "e" est transmise aux moyens de commande du déplacement de l'électrode-source qui corrigent éventuellement le positionnement de l'électrode-source par rapport à la tôle et/ou sa vitesse de déplacement et/ou les paramètres électriques de l'installation, afin que la coloration recherchée pour la zone concernée puisse être obtenue indépendammment du relief de la tôle dans cette zone.

Les installations de coloration qui viennent d'être décrites peuvent être facilement adaptées à la réalisation d'autres traitements superficiels par plasma froid d'une plaque ou d'une tôle métallique. Par exemple, pour exécuter un traitement d'amélioration de la résistance à la corrosion de la surface de la tôle ou d'une partie de celle-ci, il suffit d'inverser les polarités respectives de l'électrode-source, qui devient anode, et du support conducteur du matériau, qui devient cathode, et éventuellement de modifier les paramètres électriques de l'installation.

Enfin, pour toutes les installations qui ont été décrites, il faut préciser que d'autres moyens de production du plasma que la décharge électroluminescente entre une cathode et une anode, dont l'une est constitué par le matériau à traiter, peuvent être employées. Le plasma peut ainsi être produit par une excitation de l'atmosphère par des microondes ou par des radiofréquences. Ce qui est essentiel, c'est que des moyens soient prévus pour maintenir entre l'électrode et le matériau métallique à traiter une différence de potentiel de signe et de valeur absolue contrôlés.

L'invention s'applique au traitement superficiel de tôles et de plaques métalliques, en particulier en acier, notamment à la coloration de tôles en acier inoxydable. Elle s'applique également au traitement de tôles en acier au carbone revêtues d'une couche métallique.

## Revendications

1) Dispositif de traitement superficiel par plasma basse température d'un matériau métallique (8) immobile sous forme de plaque ou de tôle, caractérisé en ce qu'il comprend une enceinte étanche (1) munie de moyens (3,4) d'introduction d'un gaz ou d'un mélange de gaz plasmagène et de moyens (6) de régulation de la pression permettant de la maintenir à une valeur donnée, ladite enceinte (1) renfermant un support (7) en contact avec ledit matériau (8) et au moins une électrode (10,16,20) sur laquelle est ménagée une surface (13), dite surface active, faisant face audit matériau (8) et définissant un espace (12) entre elle et la surface (9) dudit matériau, l'électrode (10,16,20) étant munie de moyens (11,17,19,21) pour la maintenir et régler la distance entre sa surface active et la surface dudit matériau, des moyens (14,15) étant prévus pour créer entre ledit matériau (8) et ladite électrode (10,16,20) une différence de potentiel de signe et de valeur absolue donnés, et des moyens étant prévus pour générer un plasma basse température présent dans ledit espace.

2) Dispositif selon la revendication 1, caractérisé en ce que ledit support (7) est muni de moyens pour assurer le refroidissement dudit matériau, et en ce que ladite électrode (10,16,20) est munie de moyens pour son refroidissement.

3) Dispositif selon l'une des revendications 1 ou 2, caractérisé en ce que les moyens (14,15) pour maintenir entre ladite électrode (10,12,20) et ledit matériau (8) une différence de potentiel de signe et de valeur absolue donnés sont adaptés à l'établissement d'une décharge électroluminescente générant ledit plasma basse température entre ladite électrode (10,16,20) et la surface (9) dudit matériau (8).

4) Dispositif selon la revendication 3, caractérisé en ce que le matériau (8) est placé en anode et l'électrode (10,16,20) est placée en cathode dans le circuit de production de la décharge électroluminescente.

**5)** Dispositif selon la revendication 3, caractérisé en ce que le matériau (8) est placé en cathode et l'électrode (10,16,20) est placée en anode dans le circuit de production de la décharge luminescente.

**6)** Dispositif selon l'une des revendications 3 à 5, caractérisé en ce qu'il comprend des moyens pour créer un champ magnétique entre ladite électrode et ledit support conducteur.

**7)** Dispositif selon l'une des revendications 1 à 6, caractérisé en ce que l'aire de la surface active (13) de l'électrode (10,16,20) ne représente qu'une fraction de l'aire du matériau métallique (8) à traiter et en ce que lesdits moyens (17,19,21) pour régler la position de l'électrode (16,20) par rapport au matériau métallique (8) permettent de déplacer l'électrode (16,20) selon au moins une dimension du matériau (8) pendant l'exécution du traitement, afin de traiter la totalité ou des parties déterminées de la surface du matériau (8).

**8)** Dispositif selon la revendication 7, caractérisé en ce que l'électrode (16,20) est munie de moyens de mesure en continu de la distance entre sa surface active et la surface (9) du matériau (8) à traiter, et en ce que l'action des moyens (17,19,21) pour régler la position de l'électrode (16,20) et/ou les paramètres électriques du dispositif est asservie à ces moyens de mesure.

**9)** Dispositif selon l'une des revendications 1 à 8, caractérisé en ce que ledit matériau métallique (8) est une plaque ou une tôle d'acier inoxydable.

**10)** Dispositif selon l'une des revendications 1 à 8, caractérisé en ce que ledit matériau métallique (8) est une plaque ou une tôle d'acier revêtue d'une couche métallique.

Fig.1.

Fig.2.

Fig. 3.

EP 0 485 314 A1

**Office européen des brevets**

**RAPPORT DE RECHERCHE EUROPEENNE**

Numero de la demande

EP    91 47 0025

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | EP-A-0 340 077 (IRSID) * revendications 1-6 * | 1 | C23C8/38 C21D1/09 |
| D | & FR-A-2 630 133 --- | | |
| A | WO-A-8 500 466 (P. PARRENS) * revendications 1-16 * ----- | 1 | |

**DOMAINES TECHNIQUES RECHERCHES (Int. Cl.5)**

C23C
C21D

Le présent rapport a été établi pour toutes les revendications

| Lieu de la recherche | Date d'achèvement de la recherche | Examinateur |
|---|---|---|
| LA HAYE | 16 DECEMBRE 1991 | WITTBLAD U.A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...........................................................
& : membre de la même famille, document correspondant

EPO FORM 1503 03.82 (P0402)

10